**Europäisches Patentamt**

**European Patent Office**

**Office européen des brevets**

(19)

(11) Veröffentlichungsnummer : **0 028 415**
**B1**

(12) **EUROPÄISCHE PATENTSCHRIFT**

(45) Veröffentlichungstag der Patentschrift :
21.03.84

(51) Int. Cl.³ : **H 04 Q   3/52, H 04 N   7/14**

(21) Anmeldenummer : **80106753.9**

(22) Anmeldetag : **03.11.80**

(54) **Breitband-Koppelanordnung.**

(30) Priorität : 06.11.79 DE 2944794

(43) Veröffentlichungstag der Anmeldung :
**13.05.81 Patentblatt 81/19**

(45) Bekanntmachung des Hinweises auf die Patenterteilung : **21.03.84 Patentblatt 84/12**

(84) Benannte Vertragsstaaten :
**AT BE CH DE FR GB IT LI NL SE**

(56) Entgegenhaltungen :
**DE-B- 2 828 662**

(73) Patentinhaber : **SIEMENS AKTIENGESELLSCHAFT
Berlin und München Wittelsbacherplatz 2
D-8000 München 2 (DE)**

(72) Erfinder : **Barabas, Udo, Dr, Dipl.-Ing.
Rolf-Pinegger-Strasse 7
D-8000 München 21 (DE)** .

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Breitband-Koppelanordnung

Die Erfindung bezieht sich auf eine Koppelanordnung zum wahlweisen Durchschalten von Signalen hoher Bandbreite.

In einer solchen Breitbandkoppelanordnung können die Koppelpunktschaltkreise, deren Funktion es ist, Eingangsleitungen mit Ausgangsleitungen der Koppelanordnung wahlweise zu verbinden, im Hinblick auf möglichst kleine Schaltzeiten bzw. auf die durchzuschaltenden, vorzugsweise pulsmodulierten Signale mit Signalfrequenzen von z. B. bis über 80 MHz durch in ECL-Technik realisierte Verknüpfungsglieder gebildet sein (s. Pfannschmidt : « Arbeitsgeschwindigkeitsgrenzen von Koppelnetzwerken für Breitband-Digitalsignale », Diss. TU Bswg. 1978 ; DE-AS 28 28 662).

Mit einer solchen Breitband-Koppelanordnung können z. B. Fernsehprogramme zu Teilnehmern, die solche Programme empfangen wollen, hin vermittelt werden, wie dies neuere Entwicklungen der Fernmeldetechnik mit sich bringen, die zu Breitbandkommunikationsnetzen mit durch Lichtwellenleiter gebildeten Teilnehmerleitungen führen, wobei sich in der Teilnehmerebene ein Sternnetz von Lichtwellenleitern mit einem Lichtwellenleiter je Wohnungseinheit als günstig erweist, der eine (zweckmäßigerweise mit der nächstgelegenen Fernsprech-Vermittlungsstelle räumlich vereinigte) Breitband-Vermittlungsstelle mit der Wohnung des Teilnehmers verbindet und über den alle Fernmeldedienste für die betreffende Wohneinheit abgewickelt werden, wobei für einen zukunftssicheren Wohnungsanschluß beispielsweise die Bereitstellung zumindest etwa folgender Kommunikationsmöglichkeiten in Frage kommt :

3 Videokanäle für 3 Video-Empfänger mit unabhängigem Zugriff zu allen von der Vermittlungsstelle erreichbaren Fernsehsignalquellen bzw. in der Vermittlungsstelle verfügbaren Fernsehprogrammen,

3 Rückkanäle zur Programmauswahl und ggf. zur Abwicklung interaktiver Dienste
sowie eine größere Anzahl von UKW-Hörfunkkanälen (Stereo) (ntz 32(1979)3, 150 ... 153).

Bei einer solchen Breitbandsignalvermittlung muß ggf. einerseits mit ein und derselben Breitbandsignalquelle gleichzeitig eine Vielzahl von Teilnehmeranschlüssen verbunden werden können, während auf der anderen Seite davon auszugehen ist, daß die einzelnen Breitbandsignalquellen nicht zu niederohmig und nicht mit zu großen Schaltkapazitäten belastet werden dürfen, d. h. nicht durch eine beliebig große Anzahl von unmittelbar angeschlossenen Koppelpunktschaltern bzw. über diese Koppelpunktschalter erreichten Teilnehmern zu belasten sind ; die Erfindung zeigt einen Weg, dem in zweckmäßiger Weise Rechnung zu tragen.

Die Erfindung betrifft eine Breitband-Koppelanordnung für pulsmodulierte Breitbandsignale, bei der zur Verbindung der einzelnen Eingänge der Koppelanordnung mit den verschiedenen Ausgängen der Koppelanordnung durch ECL-Verknüpfungsglieder gebildete Koppelpunktschaltkreise vorgesehen sind ; diese Breitband-Koppelanordnung ist erfindungsgemäß dadurch gekennzeichnet, daß zur Verbindung der einzelnen Eingänge der Koppelanordnung mit den dem jeweiligen Eingang zugehörigen, zu den verschiedenen Ausgängen der Koppelanordnung führenden Koppelpunktschaltern ständig entriegelte ECL-Verknüpfungsglieder mit einer Mehrzahl von Ausgängen mit bzw. ohne Negation vorgesehen sind,
wobei Koppelpunktschalter, bei denen die Breitbandsignale in den genannten, den Koppelpunktschaltern in Kettenschaltung vorgeschalteten ECL-Verknüpfungsgliedern 2n-2 Negationen (mit n = 1, 2, ...) erfahren haben, einerseits
und Koppelpunktschalter, bei denen die Breitbandsignale in den genannten, den Koppelpunktschaltern in Kettenschaltung vorgeschalteten ECL-Verknüpfungsgliedern 2n-1 Negationen (mit n = 1, 2, ...) erfahren haben, andererseits
durch ECL-Verknüpfungsglieder mit bezüglich der pulsmodulierten Breitbandsignale miteinander vertauschter Verknüpfungsfunktion, vorzugsweise durch UND-Glieder und durch NOR-Glieder, gebildet sind.

Die Erfindung bringt den Vorteil einer merklichen Begrenzung des in der Breitband-Koppelanordnung zur Anschaltung der Eingänge bzw. der daran angeschlossenen Breitbandsignalquellen an die jeweils zugehörigen Koppelpunktschalter erforderlichen schaltungstechnischen Aufwandes mit sich.

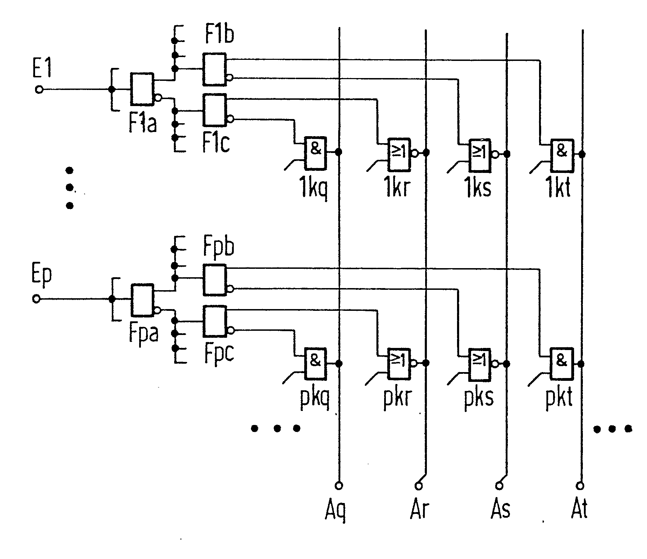

Anhand der Zeichnung sei die Erfindung noch näher erläutert.

In der Zeichnung ist schematisch in einem zum Verständnis der Erfindung erforderlichen Umfange eine Breitband-Koppelanordnung dargestellt, deren einzelne Eingangsleitungen E1 ... Ep über Koppelpunktschalter ..., 1kq, ..., pkt, ... mit Ausgangsleitungen ..., Aq, ..., At, ... verbindbar sind.

Ohne daß dies in der Zeichnung dargestellt ist, können dabei zu den Eingängen E1 ... Ep Breitbandsignalquellen führen, die insbesondere durch Fernsehprogrammquellen gegeben sein mögen, und es können die Ausgänge ..., Aq, ..., At, ... beispielsweise zu Teilnehmer-Wohnungsanschlüssen führen, über die in der eingangs erläuterten Weise jeweils eine Mehrzahl von Kommunikationsmöglichkeiten gegeben sein mag. Die Koppelpunktschalter ... 1kq, ..., pkt, ... mögen durch in ECL-Technik realisierte Verknüpfungsglieder gebildet sein, die dabei, ohne daß dies in der Zeichnung näher dargestellt ist, jeweils zu mehreren monolitischintegriert auf einen Chip zusammengefaßt sein mögen.

Davon ausgehend, daß die einzelnen Breitbandsignalquellen nicht zu niederohmig und nicht mit zu großen Schaltkapazitäten belastet werden dürfen, d. h. nicht durch eine beliebig große Anzahl von unmittelbar angeschlossenen Koppelpunktschaltern bzw. über diese Koppelpunktschalter erreichten Teilnehmern zu belasten sind, sind nun zur Auffächerung der einzelnen Eingänge E1 ... Ep der Breitband-Koppelanordnung auf die dem jeweiligen Eingang zugehörigen, zu den verschiedenen Ausgängen der Breitband-Koppelanordnung führenden Koppelpunktschalter ständig entriegelte ECL-Verknüpfungsglieder, beispielsweise des Typs 10101, mit einer Mehrzahl von Ausgängen ohne bzw. mit Negation vorgesehen. So ist im Ausführungsbeispiel einer zweistufigen Auffächerung der Eingang E1

über den nichtnegierenden Ausgang eines solchen Verknüpfungsgliedes F1a und den nichtnegierenden Ausgang eines weiteren Verknüpfungsgliedes F1b mit dem zum Ausgang At führenden Koppelpunktschalter 1kt verbunden, über den nichtnegierenden Ausgang des Verknüpfungsgliedes F1a und den negierenden Ausgang des weiteren Verknüpfungsgliedes F1b mit dem zum Ausgang As führenden Koppelpunktschalter 1ks verbunden, über den negierenden Ausgang des Verknüpfungsgliedes F1a und den nichtnegierenden Ausgang eines weiteren Verknüpfungsgliedes F1c mit dem zur Ausgangsleitung Ar führenden Koppelpunktschalter 1kr verbunden und über den negierenden Ausgang des Verknüpfungsgliedes F1a und den negierenden Ausgang des weiteren Verknüpfungsgliedes F1c mit dem zur Ausgangsleitung Aq führenden Koppelpunktschalter 1kq verbunden.

In entsprechender Weise ist der Eingang Ep der Breitband-Koppelanordnung über Verknüpfungsglieder Fpa, Fpb, Fpc mit ihrerseits ebenfalls zu den genannten Ausgängen At, As, Ar, Aq der Breitbandkoppelanordnung führenden Koppelpunktschaltern pkt, pks, pkr, pkq verbunden.

In diesem Zusammenhang ist zu bemerken, daß die genannten Verknüpfungsglieder ..., F1a, ..., Fpc, ... grundsätzlich nur eine Eingangsleitung aufzuweisen brauchen und in der Zeichnung auch nur mit einer einzigen Eingangsleitung dargestellt sind, daneben aber auch noch wenigstens eine weitere Eingangsleitung haben können, von der/denen her sie dann durch Anschaltung eines entsprechenden Entriegelungssignals ständig entriegelt, d. h. für eine Signalübertragung über den in der Zeichnung dargestellten Breitbandsignalweg vorbereitet sind.

Bei der beschriebenen Ausnutzung sowohl der Ausgänge ohne Negation als auch der Ausgänge mit Negation kann je nachdem, welcher Auffächerungsweg von einem Eingang der Breitband-Koppelanordnung zu einem bestimmten Koppelpunktschalter führt, ein durchzuschaltendes pulsmoduliertes, vorzugsweise pulscode-(PC-) oder pulsphasen-(PP-)moduliertes Breitbandsignal auf diesem Wege eine — ggf.

auch mehrfache — Negation erfahren haben oder nicht. Dabei wäre ggf. eine ungerade Anzahl von Negationen durch eine zusätzliche Negation zu kompensieren. Zweckmäßigerweise sind stattdessen jedoch, und dies zeigt auch die Zeichnung, diejenigen Koppelpunktschalter, bei denen die Breitbandsignale in den genannten, den Koppelpunktschaltern in Kettenschaltung vorgeschalteten ECL-Verknüpfungsgliedern $2n-2$ Negationen (mit $n = 1, 2, ...$) erfahren haben, einerseits und diejenigen Koppelpunktschalter, bei denen die Breitbandsignale in den genannten, den Koppelpunktschaltern in Kettenschaltung vorgeschalteten ECL-Verknüpfungsgliedern $2n-1$ Negationen (mit $n = 1, 2, ...$) erfahren haben, andererseits durch ECL-Verknüpfungsglieder (UND, NOR) mit bezüglich der pulsmodulierten Breitbandsignale miteinander vertauschter Verknüpfungsfunktion gebildet. Dabei wird unter einer Vertauschung der Verknüpfungsfunktion bezüglich der pulsmodulierten Breitbandsignale eine Vertauschung der beiden Werte der den Breitbandsignalen entsprechenden Eingangsvariablen in der Wahrheits- bzw. Arbeitstabelle der Verknüpfungsglieder verstanden. So sind die Koppelpunktschalter 1kt ... pkt und 1kq ... pkq, bei denen die Breitbandsignale auf dem Weg vom Eingang E1 bzw. Ep her keine bzw. zwei Negationen erfahren haben, durch UND-Glieder beispielsweise des Typs 10104 gebildet; die Koppelpunktschalter 1ks ... pks und 1kr ... pkr, bei denen die Breitbandsignale auf dem Weg vom Eingang E1 ... Ep her eine Negation (bzw. eine ungeradzahlige Anzahl von Negationen) erfahren haben, sind dagegen durch NOR-Glieder beispielsweise des Typs 10102 gebildet. Bei einer solchen Realisierung mit UND- und NOR-Gliedern sind übrigens die Verknüpfungsfunktionen nicht nur bezüglich der pulsmodulierten Breitbandsignale miteinander vertauscht, sondern auch bezüglich der den Koppelpunktschaltern über ihre Ansteuerleitungen zuzuführenden Steuersignale, was bedeutet, daß den Steuereingängen $\bar{s}$ der durch NOR-Glieder gebildeten Koppelpunktschalter die Steuersignale negiert zuzuführen sind.

Die Ansteuerleitungen s bzw. $\bar{s}$ der Koppelpunktschalter ..., 1kq, ..., pkt, ... können, ohne daß dies in der Zeichnung noch näher dargestellt wäre, mit den einzelnen Ausgängen eines jeweils einer Reihe von Koppelpunktschaltern, z. B. den Koppelpunktschaltern 1kt ... pkt, zugeordneten Ansteuerdecoders verbunden sein, von dem her die einzelnen Koppelpunktschalter durch zeitrichtig zugeführte Steuerimpulse jeweils impulsweise leitend gemacht werden können.

Abschließend wird noch darauf verwiesen, daß die vorstehend beschriebene Breitband-Koppelanordnung Anwendung finden kann im Rahmen eines in der EP-A1-28416 angegebenen Breitband-Vermittlungssystems zum wahlweisen Verbinden von Breitbandsignalquellen, insbe-

sondere TV-Programmquellen, mit breitband-signalempfangenden Teilnehmern über eine Breitband-Koppelanordnung, über die die Breitbandsignale, insbesondere TV-Signale, als pulsmodulierte Signale übertragen werden, in welchem die Signale der einzelnen Signalquellen dem jeweiligen signalquellenindividuellen Eingang der Breitband-Koppelanordnung jeweils im Zeitmultiplex in einer der Anzahl der gleichzeitig mit ein und demselben Teilnehmer verbindbaren Signalquellen entsprechenden Mehrzahl von Zeitkanälen eines zumindest diese Zeitkanäle umfassenden Zeitmultiplexsystems mehrfach zugeführt werden und in der Breitband-Koppelanordnung die teilnehmerindividuellen Ausgänge jeweils in teilnehmerindividuell bestimmten Zeitkanälen der genannten Mehrzahl von Zeitkanälen mit der jeweils gewünschten Signalquelle verbunden werden.

**Ansprüche**

1. Breitband-Koppelanordnung für pulsmodulierte Breitbandsignale, bei der zur Verbindung der einzelnen Eingänge (E1 ... Ep) der Koppelanordnung mit den verschiedenen Ausgängen (..., Aq, ..., At, ...) der Koppelanordnung durch ECL-Verknüpfungsglieder gebildete Koppelpunktschaltkreise (1kq, ..., pkt) vorgesehen sind, dadurch gekennzeichnet, daß zur Verbindung der einzelnen Eingänge (E1 ... Ep) der Koppelanordnung mit den dem jeweiligen Eingang (Ep) zugehörigen, zu den verschiedenen Ausgängen (..., Aq, ... At, ...) der Koppelanordnung führenden Koppelpunktschaltern (..., pkq, ..., pkt, ...) ständig entriegelte ECL-Verknüpfungsglieder (Fpa, Fpb, Fpc) mit einer Mehrzahl von Ausgängen mit bzw. ohne Negation vorgesehen sind, wobei Koppelpunktschalter (pkt, pkq), bei denen die Breitbandsignale in den genannten, den Koppelpunktschaltern (pkt, pkq) in Kettenschaltung vorgeschalteten ECL-Verknüpfungsgliedern (Fpa, Fpb ; Fpa, Fpc) 2n-2 Negationen (mit n = 1, 2, ...) erfahren haben, einerseits und Koppelpunktschalter (pkr, pks), bei denen die Breitbandsignale in den genannten, den Koppelpunktschaltern (pkr, pks) in Kettenschaltung vorgeschalteten ECL-Verknüpfungsgliedern (Fpa, Fpc ; Fpa, Fpb) 2n-1 Negationen (mit n = 1, 2, ...) erfahren haben, andererseits durch ECL-Verknüpfungsglieder (UND, NOR) mit bezüglich der pulsmodulierten Breitbandsignale miteinander vertauschter Verknüpfungsfunktion gebildet sind.

2. Breitbandkoppelanordnung nach Anspruch 1, dadurch gekennzeichnet, daß die Koppelpunktschalter durch UND-Glieder und durch NOR-Glieder gebildet sind.

**Claims**

1. A wide band coupling arrangement for pulse-modulated wide band signals, wherein coupling point switching circuits (1kq, ..., pkt) formed by ECL logic elements are provided to connect the individual inputs (E1 ... Ep) of the coupling arrangement to the different outputs (..., Aq, ..., At) of the coupling arrangement, characterised in that permanently unblocked ECL logic elements (Fpa, Fpb, Fpc) having a plurality of outputs with or without negation, as the case may be, are provided, to connect the individual inputs (E1 ... Ep) of the coupling arrangement to the coupling point switches (..., pkq, ..., pkt, ...) assigned to the respective input (Ep) and leading to the different outputs (..., Aq, ... At, ...) of the coupling arrangement, where on the one hand those coupling point switches (pkt, pkq) where the wide band signals have been subjected to 2n-2 negations (n = 1, 2, ...) in said ECL logic elements (Fpa, Fpb ; Fpa, Fpc) which precede the coupling point switches (pkt, pkq) in a chain connection, and on the other hand those coupling point switches (pkr, pks) where the wide band signals have been subjected to 2n-1 negations (n = 1, 2, ...) in said ECL logic elements (Fpa, Fpc ; Fpa, Fpb) which precede the coupling point switches (pkr, pks) in a chain connection, are formed by ECL logic elements (AND, NOR) which have a mutually exchanged logic function in respect of the pulse-modulated wide band signals.

2. A wide band coupling arrangement as claimed in Claim 1, characterised in that the coupling point switches are formed by AND elements and by NOR elements.

**Revendications**

1. Dispositif de couplage à large bande pour des signaux à large bande modulés, par impulsions, dans lequel pour relier les différentes entrées (E1 ... Ep) du dispositif de couplage aux différentes sorties (..., Aq, ... At, ...) de ce dispositif, il est prévu des circuits de points de couplage (1kq, ... pkt) formés par des circuits logiques ECL, caractérisé par le fait que pour relier les différentes entrées (E1 ... Ep) du dispositif de couplage aux commutateurs de points de couplage (..., pkq, ... pkt, ...) associés aux entrées respectives (Ep) et aboutissant aux différentes sorties (..., Aq, ..., At, ...) du dispositif de couplage, il est prévu des circuits logiques ECL (Fpa, Fpb, Fpc) déverrouillés en permanence et comportant une multiplicité de sorties avec et sans inversion, et que d'une part les commutateurs de points de couplage (pkt, pkq), dans le cas desquels les signaux à large bande ont subi (2n-2) inversions (avec n = 1, 2, ...) dans les circuits logiques ECL (Fpa, Fpb ; Fpa, Fpc) indiqués branchés en amont des commutateurs de points de couplage (pkt, pkq) selon un montage itératif, et d'autre part les commutateurs de points de couplage (pkr, pks), dans le cas desquels les signaux à large bande ont subi (2n-1) inversions (avec n = 1, 2, ...) dans les circuits logiques ECL (Fpa, Fpc ; Fpa, Fpb) indiqués branchés en amont des commutateurs de points de couplage (pkr, pks) selon un montage itératif, sont constitués par des circuits logiques ECL (ET, NON) ayant des fonctions de combinaison logique permutées entre elles en rapport avec les signaux à large bande modulés par impulsions.

2. Dispositif de couplage à large bande suivant la revendication 1, caractérisé par le fait que les commutateurs de points de couplage sont formés par des circuits ET et par des circuits NON-OU.